# EUROPEAN PATENT APPLICATION

(11) **EP 3 920 419 A1**
(43) Date of publication of application: **08.12.2021**
(21) Application number: 21173706.9
(22) Date of filing: 12.05.2021
(51) Int. Cl.: H03K 17/96, H03K 17/955, H05K 1/18

(54) **TOUCH SWITCH SYSTEM WITH A DISPLAY**

(30) Priority: 15.05.2020 PL 43398020
(71) Applicant: Amica S.A., 64-510 Wronki (PL)
(72) Inventor: JENEK, Tomasz, 64-510 Wronki (PL); SWITALA, Wojciech, 62-081 Baranowo (PL); TARANCZEWSKI, Mieszko, 64-500 Szamotu y (PL)
(74) Representative: Gornicki, Pawel

(57) **Abstract**

The touch switch system with display comprises a touch sensor (3), a display (2), a unit for processing signals generated by the touch sensor and the display control unit, mounted on a printed circuit board (1) and characterized in that the display (2) is mounted in a hole (via) (7) of the printed circuit board (1) in such a way that the display screen surface (2) and the printed circuit board front surface (1) are flush. The printed circuit board (1) has one or more conductive layers (11,12,13,14), and the outputs (8) of the display (2) are connected with the contacts (5) located on the conductive layer (14) on the back surface of the printed circuit board (1). The outputs (8) of the display (2) are connected through the contacts (5) with the traces (6) routed to the unit controlling the symbols shown on the display, transmitting the signals sent by the control unit to the display outputs. The touch sensor (3) is a trace routed on one of the conductive layers (11,12,13,14) of the printed circuit board (1) around the hole (via) (7) in which the display (2) is mounted. The touch sensor trace (3) is connected to the trace (4) transmitting the signals generated by the touch sensor (3) to the signal processing unit; the trace transmitting the signals generated by the touch sensor (3) to the signal processing system and the traces (6) transmitting the control signals from the control system to the outputs of the display (8) are routed on any conductive layer (11,12,13,14) of the printed circuit board (1).

## Description

The subject of the invention is a touch switch system with a display, especially for use in home appliance touch control systems. The switch can perform both the function of monostable or bistable switching as well as other functions based on the detection of touch, absence of touch, approaching the finger, as well as detecting the distance of the finger from the user interface surface and the position of the user's finger.

In known touch switch systems with displays, the sensor touch surface is located just below the user interface surface, and the display and control system are mounted on a printed circuit board that is spaced from the user interface surface and the touch sensor touch surface at least by the height of the display. Conductive elements, such as rubber elements, plates, springs, plastic foams or sponges, which constitute the electrical connection of the touch sensor to the printed circuit board or processing system, are used to deliver the signals from the sensor touch surface to the signal processing system on the printed circuit board. Typically, the top surface of these conductive elements is the touch sensor surface.

The European patent document EP1257057 B1 describes a sensor of a capacitive touch switch with the possibility of displaying the touch switch function or state within the sensor surface. The touch sensor surface is located directly under a transparent working surface, e.g. a cooking surface, which is the user interface. The function display light source and the control system are mounted on a printed circuit board located under the working surface. The printed circuit board is some distance from the working surface and the touch sensor surface, so the touch sensor surface is connected to the printed circuit board or to the touch switch control circuit via a flexible conductive pin.

The purpose of the solution according to the invention is to provide a touch switch system with a display in which the sensor touch surface is directly connected to the printed circuit board, possibly to the signal processing system mounted thereon, so as to eliminate the conductive elements such as rubber elements, foams and the like.

The touch switch system with a display comprises a touch sensor and a display, as well as a unit processing signals generated by the touch sensor and the display control unit, mounted on the printed circuit board and characterized in that the display is mounted in the printed circuit board hole (via) in such a way that the display screen surface and the printed circuit board front surface are flush. The printed circuit board has one or more conductive layers, and the display outputs are connected with the contacts located on the conductive layer on the back surface of the printed circuit board, and, through the contacts, with the traces routed to the unit controlling the symbols shown on the display, transmitting the signals sent by the control unit to the display outputs. The system touch sensor is a trace routed on one of the conductive layers of the printed circuit board around the hole (via) in which the display is located and the trace is connected to the trace transmitting the signals generated by the touch sensor to the signal processing unit. The trace transmitting the signals generated by the touch sensor to the signal processing system, and the traces transmitting control signals from the control system to the display outputs, are routed on any conductive layer of the printed circuit board.

Preferably, the trace constituting the touch sensor is routed on the conductive layer of the printed circuit board located on the outer front surface of the printed circuit board.

Preferably, the trace constituting the touch sensor is routed on the conductive layer of the printed circuit board located inside the printed circuit board.

Preferably, the trace constituting the touch sensor is routed on the conductive layer of the printed circuit board located on the outer back surface of the printed circuit board.

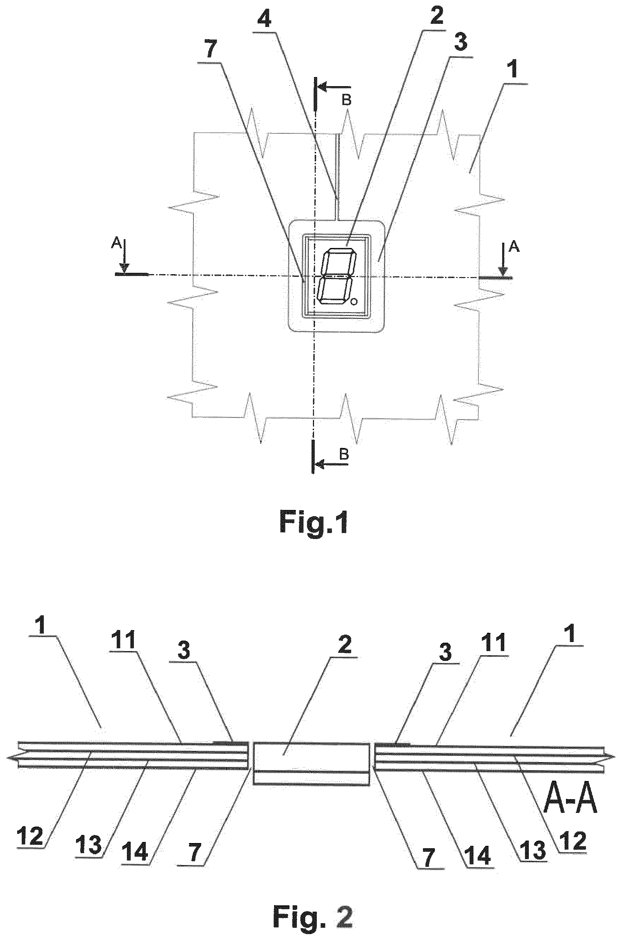

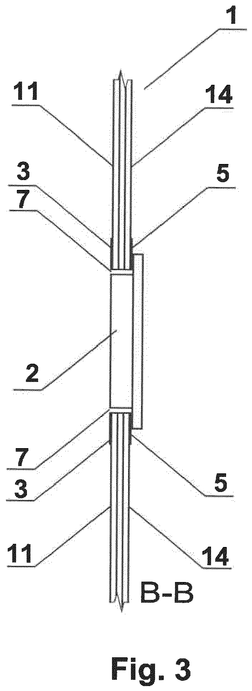

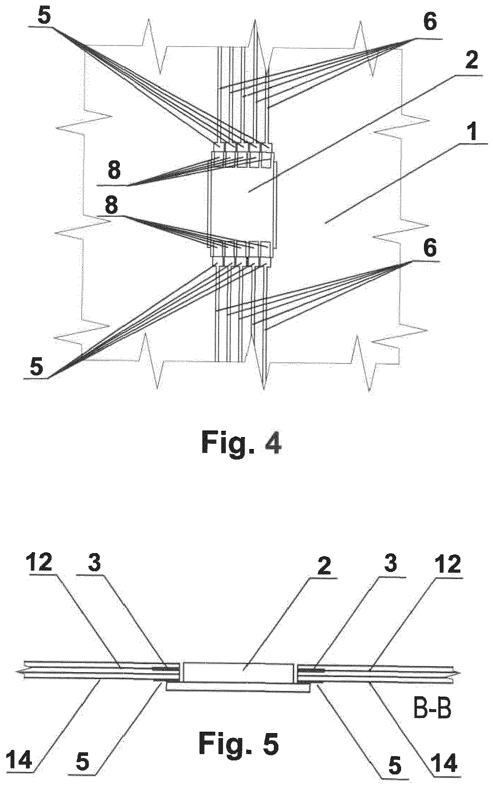

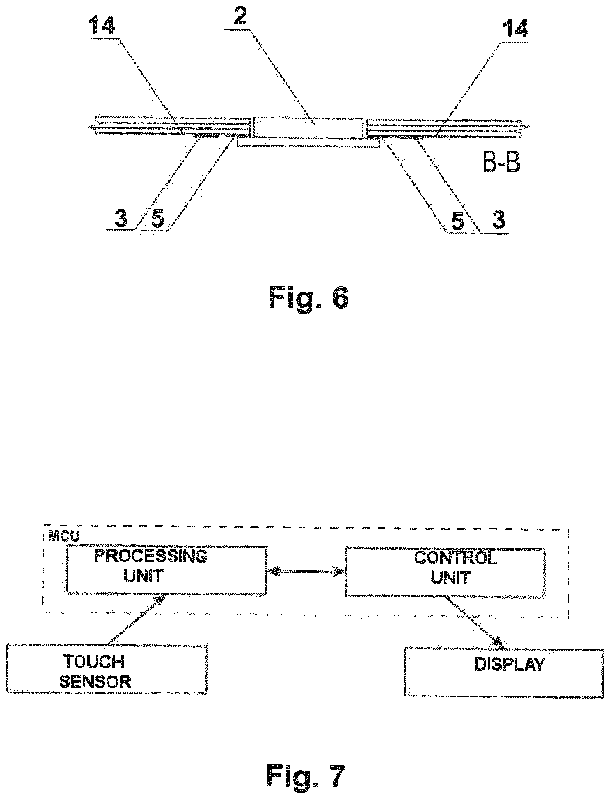

The subject of the invention is explained in more detail in the embodiment shown in the figures; Figures 1 to 4 show an example in which the printed circuit board has four conductive layers, and the touch sensor trace is routed on the conductive layer located on the printed circuit board front surface, Fig. 5 shows an example in which the touch sensor trace is routed on one of the inner conductive layers of the printed circuit board, Fig. 6 shows an example in which the touch sensor trace is routed on the conductive layer located on the outer back surface of the printed circuit board, while Fig. 7 shows the block diagram of the touch switch system with display. The individual Figures 1 to 6 show: Fig. 1 - view of a fragment of the conductive layer of the printed circuit board located on the front surface of the printed circuit board with a touch sensor and display, Fig. 2 - cross-sectional view of the printed circuit board along the line A-A in Fig. 1, Fig. 3 - cross-sectional view of the printed circuit board along the line B-B in Fig. 1, Fig. 4 - view of a fragment of the conductive layer of the printed circuit board located on the outer back surface of the printed circuit board with display, Fig. 5 - cross-sectional view of the printed circuit board along the line B-B in Fig. 1, in which the touch sensor trace is routed in the inner conductive layer of the printed circuit board, Fig. 6 - cross-sectional view of the printed circuit board along the line B-B in Fig. 1 in which the touch sensor trace is routed on the conductive layer located on the outer back surface of the printed circuit board,

In the printed circuit board **1** there is a hole (via) **7**in which the display **2** is mounted in such a way that the display screen surface **2** and the printed circuit board front surface **1** are flush, and the outputs **8** of the display **2** are connected with the contacts **5** on the conductive layer **14** of the printed circuit board **1**, located on the outer back surface of the printed circuit board **1.** The contacts **5** are connected with the traces **6** that transmit the signals from the control unit to the outputs **8** of the display **2**. The traces **6** may be routed in any conductive layer **11, 12, 13, 14** of the printed circuit board **1**. On the conductive layer **11**, located on the front outer surface of the printed circuit board **1**, around the hole (via) **7** in which the display **2** is mounted, a trace constituting the touch sensor is routed **3**. The signals generated by the touch sensor **3** are transmitted to the processing unit via the trace **4**, which may be routed in any conductive layer **11, 12, 13, 14** of the printed circuit board **1**.

In another embodiment, the trace constituting the touch sensor **3** is routed on the inner conductive layer **12** of the printed circuit board **1**, as shown in Fig. 5 showing the cross-sectional view of the printed circuit board along the line B-B in Fig. 1.

Yet another embodiment shows the cross-sectional view of the printed circuit board in Fig. 6, in which the trace constituting the touch sensor **3** is routed in the outer conductive layer **14**, located on the back surface of the printed circuit board **1**.

The touch switch system with display made in this way can be placed in the immediate vicinity of the user interface surface, without the need to use conductive elements for transmitting signals from the touch sensor to the signal processing system.

### List of symbols:

**1** - printed circuit board,
**11** - conductive layer located on the outer front surface of the printed circuit board **1**,
**12**, **13** - internal conductive layers of the printed circuit board **1**,
**14** - conductive layer located on the outer back surface of the printed circuit board **1**,
**2** - display,
**3** - touch sensor,
**4** - trace transmitting signals from the touch sensor **3** to the signal processing system
**5** - contacts connecting the display outputs **8** with the traces **6** on the outer lower conducting layer **14** of the printed circuit board **1**,
**6** - traces routed from the control system to the outputs **8** of the display **2,**
**7** - hole (via) in the printed circuit board **1** for the body of the display**2**,
**8** - display outputs.

## Claims

1. The touch switch system with display comprising a touch sensor, a display, a unit processing signals generated by the touch sensor and the display control unit, mounted on one or more printed circuit boards, **characterized in that** the display (2) is mounted in a hole (via) (7) of the printed circuit board (1) in such a way that the display screen surface (2) and the front surface of the printed circuit board (1) are flush; the printed circuit board (1) has one or more conductive layers (11, 12, 13, 14), and the outputs (8) of the display (2) are connected with the contacts (5) located on the conductive layer (14) on the back surface of the printed circuit board (1), and, through the contacts (5), with the traces (6) routed to the unit controlling the symbols shown on the display, transmitting the signals sent by the control unit to the display outputs; the touch sensor (3) is a trace routed on one of the conductive layers (11,12,13,14) of the printed circuit board (1) around the hole (via) (7) in which the display (2) is mounted, which trace is connected to the trace (4) transmitting the signals generated by the touch sensor (3) to the signal processing unit; the trace transmitting the signals generated by the touch sensor (3) to the signal processing system and the traces (6) transmitting the control signals from the control system to the outputs of the display (8) are routed on any conductive layer (11,12,13,14) of the printed circuit board (1).

2. The system according to claim 1, **characterized in that** the trace constituting the touch sensor (3) is routed on the conductive layer (11) located on the outer front surface of the printed circuit board (1).

3. The system according to claim 1, **characterized in that** the trace constituting the touch sensor (3) is routed on one of the inner conductive layers (12, 13) of the printed circuit board (1).

4. The system according to claim 1, **characterized in that** the trace constituting the touch sensor (3) is routed on the conductive layer (14) located on the outer back surface of the printed circuit board (1).
